# FASCICULE DE BREVET EUROPEEN

(11) **EP 3 991 214 B1**
(45) Date de publication et mention de la délivrance du brevet: **26.07.2023**
(21) Numéro de dépôt: 20734740.2
(22) Date de dépôt: 25.06.2020
(51) Int. Cl.: H01L 33/00, H01L 33/18, H01L 33/20, H01L 33/06, H01L 33/08, H01L 33/32

(54) **PROCÉDÉ DE FABRICATION D'UN DISPOSITIF OPTOÉLECTRONIQUE À DIODES ÉLECTROLUMINESCENTES DE TYPE AXIAL**
VERFAHREN ZUR HERSTELLUNG EINER OPTOELEKTRONISCHEN VORRICHTUNG MIT LEUCHTDIODEN DES AXIALEN TYPS
METHOD FOR MANUFACTURING AN OPTOELECTRONIC DEVICE WITH AXIAL-TYPE LIGHT-EMITTING DIODES

(30) Priorité: 25.06.2019 FR 1906899
(43) Date de publication de la demande: 04.05.2022
(73) Titulaire: Commissariat à l'Energie Atomique et aux Energies Alternatives, 75015 Paris (FR); Aledia, 38130 Echirolles (FR); Université Grenoble Alpes, 38400 Saint-Martin-d'Hères (FR)
(72) Inventeur: DAUDIN, Bruno-Jules, 38054 Grenoble Cedex 9 (FR); CHIKHAOUI, Walf, 38500 Voiron (FR); GRUART, Marion, 38120 Saint-Égrève (FR)
(74) Mandataire: Cabinet Beaumont
(86) Numéro de dépôt international: PCT/EP2020/067967
(87) Numéro de publication internationale: WO 2020/260546

(56) Documents cités:
- EP-A1- 2 290 710
- WO-A1-2019/002786
- US-A1- 2007 248 132
- KATSUMI KISHINO ET AL: "Monolithic Integration of InGaN-Based Nanocolumn Light-Emitting Diodes with Different Emission Colors", APPLIED PHYSICS EXPRESS, vol. 6, no. 1, 21 décembre 2012 (2012-12-21), page 012101, XP055668991, JP ISSN: 1882-0778, DOI: 10.7567/APEX.6.012101
- YONG-HO RA ET AL: "Full-Color Single Nanowire Pixels for Projection Displays", NANO LETTERS, vol. 16, no. 7, 22 juin 2016 (2016-06-22), pages 4608-4615, XP055668994, US ISSN: 1530-6984, DOI: 10.1021/acs.nanolett.6b01929
- Veeco: "GENxplor R&D MBE System", Veeco, Technologies & Products, MBE Technologies, MBE Systems, Data Sheet, 1 janvier 2014 (2014-01-01), pages 1-2, XP055669002, Extrait de l'Internet: URL:https://veeco.s3.amazonaws.com/5ff68c2 8300e8ec266da97cd3403f191.pdf [extrait le 2020-02-14]
- KIKUCHI A ET AL: "INGAN/GAN MULTIPLE QUANTUM DISK NANOCOLUMN LIGHT-EMITTING DIODES GROWN ON (111) SI SUBSTRATE", JAPANESE JOURNAL OF APPLIED PHYSICS, JAPAN SOCIETY OF APPLIED PHYSICS, JP, vol. 43, no. 12A, 1 décembre 2004 (2004-12-01), pages L1524-L1526, XP001230716, ISSN: 0021-4922, DOI: 10.1143/JJAP.43.L1524
- FOXON C T ET AL: "A complementary geometric model for the growth of GaN nanocolumns prepared by plasma-assisted molecular beam epitaxy", JOURNAL OF CRYSTAL GROWTH, ELSEVIER, AMSTERDAM, NL, vol. 311, no. 13, 15 juin 2009 (2009-06-15), pages 3423-3427, XP026185464, ISSN: 0022-0248, DOI: 10.1016/J.JCRYSGRO.2009.04.021 [extrait le 2009-05-03]

## Description

La présente demande de brevet revendique la priorité de la demande de brevet français FR19/06899.

### Domaine technique

La présente invention concerne de façon générale les dispositifs optoélectroniques à diodes électroluminescentes comprenant des éléments semiconducteurs tridimensionnels, par exemple des microfils, des nanofils, des éléments coniques de taille micrométrique ou nanométrique, ou des éléments tronconiques de taille micrométrique ou nanométrique et les procédés de fabrication de tels dispositifs.

### Technique antérieure

On considère ici plus particulièrement l'amélioration des dispositifs optoélectroniques à diodes électroluminescentes du type axial, comprenant une zone active formée au sommet de chaque élément tridimensionnel. On appelle zone active de la diode électroluminescente la région depuis laquelle est émise la majorité du rayonnement électromagnétique fourni par la diode électroluminescente.

Les éléments tridimensionnels considérés ici comprennent un matériau semiconducteur comportant majoritairement un élément du groupe III et un élément du groupe V (par exemple du nitrure de gallium GaN), appelé par la suite composé III-V. De tels dispositifs sont, par exemple, décrits dans le brevet US 9 728 680 B2.

Chaque zone active est prise en sandwich entre l'élément semiconducteur tridimensionnel associé, qui est généralement dopé d'un premier type de conductivité, et une couche semiconductrice du même composé III-V que l'élément semiconducteur et dopée du type de conductivité opposé.

Un exemple de procédé de fabrication du dispositif optoélectronique comprend la formation des éléments semiconducteurs, des zones actives et des couches semiconductrices en jouant sur les paramètres de croissance pour favoriser une croissance cristalline axiale. Il peut toutefois ne pas être possible d'empêcher complètement la formation de la couche semiconductrice sur les parois latérales de la zone active et de l'élément semiconducteur tridimensionnel associé. Ceci peut entraîner la formation de passages pour le courant court-circuitant la zone active, entraînant une diminution des performances d'émission du dispositif optoélectronique. Ce problème connu est évoqué, par exemple, dans l'article de Katsumi Kishino et al.: "Monolithic Intégration of InGaN-Based Nanocolumn Light-Emitting Diodes with Différent Emission Colors", Applied Physics Express, vol. 6, no. 1, 21 décembre 2012, pages 012101-1 à 3. La solution conventionnelle à ce problème consiste, comme brièvement évoqué dans ce même article, à passiver les flancs des nano-colonnes afin de supprimer tout courant de fuite court-circuitant les zones actives. Le document WO 2019/002786 A1 décrit un procédé de fabrication d'un dispositif optoélectronique à diodes électroluminescentes de type axial et renvoie, notamment, à l'article ci-dessus. Résumé de l'invention

La présente invention porte sur un procédé de fabrication d'un dispositif optoélectronique tel que défini par la revendication 1 en annexe.

Les revendications dépendantes en annexe couvrent d'autres modes avantageux de réalisation de la présente invention.

Ainsi, un objet d'un mode de réalisation est de pallier au moins en partie les inconvénients des dispositifs optoélectroniques décrits précédemment et de leurs procédés de fabrication.

Un autre objet d'un mode de réalisation est d'améliorer les performances d'émission du dispositif optoélectronique à diodes électroluminescentes du type axial.

Ainsi, la présente invention prévoit un procédé de fabrication d'un dispositif optoélectronique comprenant des diodes électroluminescentes comprenant la formation d'éléments semiconducteurs tridimensionnels, s'étendant selon des axes parallèles, en un composé III-V, et comprenant chacun une portion inférieure et une portion supérieure évasée par rapport à la portion inférieure et inscrite dans un tronc de cône de demi-angle au sommet α. Le procédé comprend en outre, pour chaque élément semiconducteur, la formation d'une zone active recouvrant le sommet de la portion supérieure et la formation d'au moins une couche semiconductrice du composé III-V recouvrant la zone active par dépôt sous phase vapeur à une pression inférieure à 10 mPa, en utilisant un flux de l'élément du groupe III selon une première direction inclinée d'un angle θ_{III} et un flux de l'élément du groupe V selon une deuxième direction inclinée d'un angle θ_{V} par rapport à l'axe vertical, le plus grand des deux angles θ_{III} et θ_{V} étant inférieur strictement à l'angle α.

Selon un mode de réalisation, les couches semiconductrices sont formées par épitaxie par jets moléculaires.

Selon un mode de réalisation, le rapport III/V, pour la formation des couches semiconductrices, est inférieur à 1,4, de préférence inférieur à 1,3.

Selon un mode de réalisation, l'angle α est strictement supérieur à 0°, de préférence compris entre 5° et 50°, plus préférentiellement compris entre 5° et 30°.

Selon un mode de réalisation, les portions supérieures des éléments semiconducteurs tridimensionnels sont formées par épitaxie par jets moléculaires.

Selon un mode de réalisation, le rapport III/V, pour la formation des portions supérieures des éléments semiconducteurs tridimensionnels, est supérieur à 1,1.

Selon un mode de réalisation, les portions inférieures des éléments semiconducteurs tridimensionnels sont formées par épitaxie par jets moléculaires.

Selon un mode de réalisation, le rapport III/V, pour la formation des portions inférieures des éléments semiconducteurs tridimensionnels, est inférieur à 1,4.

Selon un mode de réalisation, la température lors de la formation des portions supérieures des éléments semiconducteurs tridimensionnels est inférieure d'au moins 50°C à la température lors de la formation des portions inférieures des éléments semiconducteurs tridimensionnels.

Selon un mode de réalisation, les zones actives sont formées par épitaxie par jets moléculaires.

Selon un mode de réalisation, les portions inférieures des éléments semiconducteurs tridimensionnels sont des microfils, des nanofils, des éléments coniques de taille micrométrique ou nanométrique, ou des éléments tronconiques de taille micrométrique ou nanométrique.

Selon un mode de réalisation, les zones actives sont les régions depuis lesquelles est émise la majorité du rayonnement électromagnétique fourni par les diodes électroluminescentes.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un exemple d'un dispositif optoélectronique à diodes électroluminescentes du type axial obtenu selon des conditions de fabrication idéales, utiles à la compréhension de la présente invention telle que revendiquée mais n'en faisant, strictement en soi, pas partie ;
la figure 2 est une vue en coupe analogue à la figure 1 du dispositif optoélectronique obtenu selon des conditions de fabrication réelles, utiles de nouveau à la compréhension de la présente invention telle que revendiquée mais n'en faisant, en soi, toujours pas partie ;
la figure 3 est une image obtenue par microscopie électronique en transmission à balayage d'une partie du dispositif de la figure 2 ;
la figure 4 représente un mode de réalisation d'un dispositif optoélectronique à diodes électroluminescentes du type axial fabriqué d'après le procédé selon la présente invention telle que revendiquée ;
la figure 5 illustre une étape d'un mode de réalisation d'un procédé de fabrication du dispositif optoélectronique représenté en figure 4 ;
la figure 6 illustre une autre étape du procédé ;
la figure 7 illustre une autre étape du procédé ;
la figure 8 illustre une autre étape du procédé ; et
la figure 9 est une image obtenue par microscopie électronique à balayage d'une partie du dispositif de la figure 4.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les étapes et éléments utiles à la compréhension des modes de réalisation décrits ont été représentés et sont détaillés. En particulier, les moyens de commande des dispositifs optoélectroniques sont bien connus et ne sont pas décrits.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un dispositif optoélectronique dans une position normale d'utilisation.

Sauf précision contraire, les expressions "environ", "approximativement", "sensiblement", et "de l'ordre de" signifient à 10 % près, de préférence à 5 % près. En outre, on considère ici que les termes "isolant" et "conducteur" signifient respectivement "isolant électriquement" et "conducteur électriquement".

La présente description concerne des dispositifs optoélectroniques comprenant des éléments semiconducteurs tridimensionnels, par exemple des microfils, des nanofils, des éléments coniques de taille micrométrique ou nanométrique, ou des éléments tronconiques de taille micrométrique ou nanométrique. En particulier, un élément conique ou tronconique peut être un élément conique circulaire ou tronconique circulaire ou un élément conique pyramidal ou tronconique pyramidal. Dans la suite de la description, des modes de réalisation sont décrits pour des dispositifs optoélectroniques comprenant des microfils ou des nanofils. Toutefois, ces modes de réalisation peuvent être mis en oeuvre pour des éléments semiconducteurs autres que des microfils ou des nanofils, par exemple des éléments coniques ou tronconiques.

Le terme "microfil", "nanofil", "élément conique" ou "élément tronconique" désigne une structure tridimensionnelle de forme allongée, par exemple cylindrique, conique ou tronconique, selon une direction privilégiée, appelée axe par la suite, dont au moins deux dimensions, appelées dimensions mineures, sont comprises entre 5 nm et 2,5 µm, de préférence entre 50 nm et 1 µm, la troisième dimension, appelée dimension majeure, étant supérieure ou égale à 1 fois, de préférence supérieure ou égale à 5 fois et encore plus préférentiellement supérieure ou égale à 10 fois, la plus grande des dimensions mineures, par exemple comprise entre 1 µm et 50 µm.

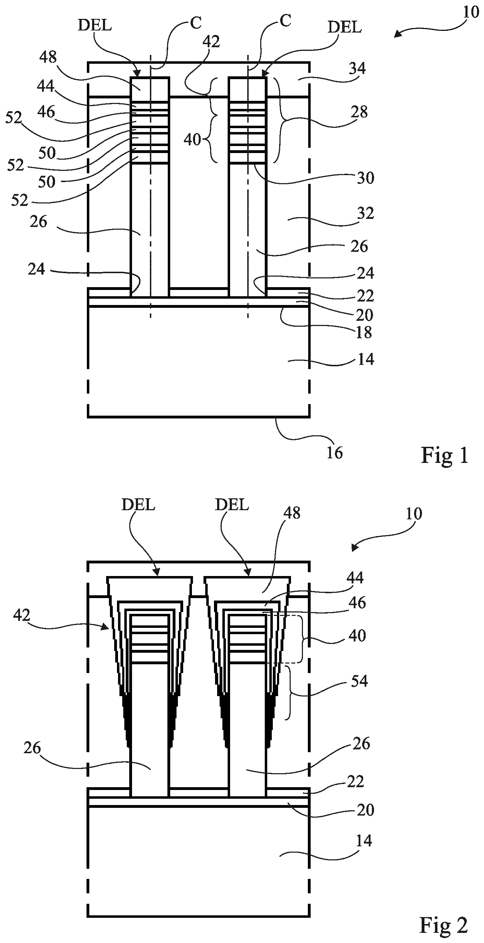

La figure 1 est une vue en coupe, partielle et schématique, d'un exemple d'un dispositif optoélectronique 10 à diodes électroluminescentes de type axial. Le dispositif optoélectronique 10 comprend du bas vers le haut en figure 1 :
- un substrat 14, par exemple un substrat semiconducteur, comprenant des faces parallèles 16 et 18, de préférence planes, la face 18 étant traitée pour promouvoir la croissance de fils. Ce traitement est représenté de façon schématique en figure 1 par une couche 20 de germination en un matériau favorisant la croissance des fils, sur la face 18 du substrat 14 ;
- une couche isolante 22 recouvrant la couche de germination 20 et comprenant des ouvertures 24 traversantes ;
- des fils 26 d'axes C parallèles, deux fils 26 étant représentés sur la figure 1 au moins en partie dopés d'un premier type de conductivité, par exemple dopés de type n ;
- pour chaque fil 26, une tête 28 recouvrant le sommet 30 du fil 26 ;
- une couche isolante 32 recouvrant les faces latérales des fils 26 et partiellement les faces latérales des têtes 28 ; et
- une couche d'électrode 34 recouvrant la couche isolante 32 et en contact avec les têtes 28.

Le dispositif optoélectronique 10 comprend une autre électrode, non représentée, pour polariser la base des fils 26.

Chaque tête 28 comprend du bas vers le haut en figure 1 :
- une zone active 40 recouvrant le sommet 30 du fil 26 ; et
- un empilement semiconducteur 42 recouvrant la zone active 40 et comprenant une couche semiconductrice 44 dopée d'un deuxième type de conductivité opposé à celui du fil 26, par exemple dopée de type p, et recouvrant la zone active 40.

L'ensemble formé par chaque fil 26 et la tête 28 associée forme une diode électroluminescente DEL en configuration axiale.

L'empilement semiconducteur 42 peut en outre comprendre une couche de blocage d'électrons 46 entre la zone active 40 et la couche semiconductrice 44 et une couche semiconductrice de liaison 48 recouvrant la couche semiconductrice 44 du côté opposé à la zone active 40, la couche de liaison 48 étant recouverte par la couche d'électrode 34. La couche de blocage d'électrons 46 en contact avec la zone active 40 et la couche semiconductrice 44 permet d'optimiser la présence des porteurs électriques dans la zone active 40. La couche de liaison 48 peut être du même matériau que la couche semiconductrice 44 et dopée du même type de conductivité que la couche semiconductrice 44 mais avec une concentration de dopants plus importante pour permettre la formation d'un contact ohmique entre la couche semiconductrice 44 et la couche d'électrode 34.

La zone active 40 est la zone de la diode électroluminescente DEL depuis laquelle est émise la majorité du rayonnement électromagnétique fourni par la diode électroluminescente DEL. Selon un exemple, la zone active 40 peut comporter des moyens de confinement. La zone active 40 peut comprendre au moins un puits quantique, comprenant une couche d'un matériau semiconducteur ayant une énergie de bande interdite inférieure à celle du fil 26 et de la couche semiconductrice 44, de préférence interposée entre deux couches barrières, améliorant ainsi le confinement des porteurs de charge, les couches barrières pouvant être du même matériau que le fil 26 et non intentionnellement dopées. La zone active 40 peut être formée d'un seul puits quantique ou d'une pluralité de puits quantiques. A titre d'exemple, en figure 1, on a représenté une alternance selon l'axe C de deux puits quantiques 50 et de trois couches barrières 52.

Un exemple de procédé de fabrication du dispositif optoélectronique 10 comprend la croissance des fils 26, des zones actives 40 et des empilements semiconducteurs 42 en mettant en oeuvre un procédé de croissance qui favorise une croissance cristalline selon l'axe C des fils 26. Le procédé de croissance des fils peut être un procédé du type dépôt chimique en phase vapeur (CVD, sigle anglais pour Chemical Vapor Déposition) ou dépôt chimique en phase vapeur aux organométalliques (MOCVD, acronyme anglais pour Metal-Organic Chemical Vapor Déposition), également connu sous le nom d'épitaxie organométallique en phase vapeur (ou MOVPE, acronyme anglais pour Metal-Organic Vapor Phase Epitaxy), ou un procédé tel que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PA-MBE), dépôt par couches minces atomiques (ALD, acronyme anglais pour Atomic Layer Déposition) ou l'épitaxie en phase vapeur aux hydrures (HVPE, acronyme anglais pour Hydride Vapor Phase Epitaxy ou Halide Vapor Phase Epitaxy) peuvent être utilisés. Toutefois, des procédés électrochimiques peuvent être utilisés, par exemple le dépôt en bain chimique (CBD, sigle anglais pour Chemical Bath Déposition), les procédés hydrothermiques, la pyrolise d'aérosol liquide ou l'électrodépôt.

La structure représentée en figure 1 illustre la structure idéale visée. Toutefois, en pratique, il peut ne pas être possible d'empêcher complètement la formation des couches de l'empilement semiconducteur 42 sur les parois latérales de la zone active 40 et du fil 26 associé.

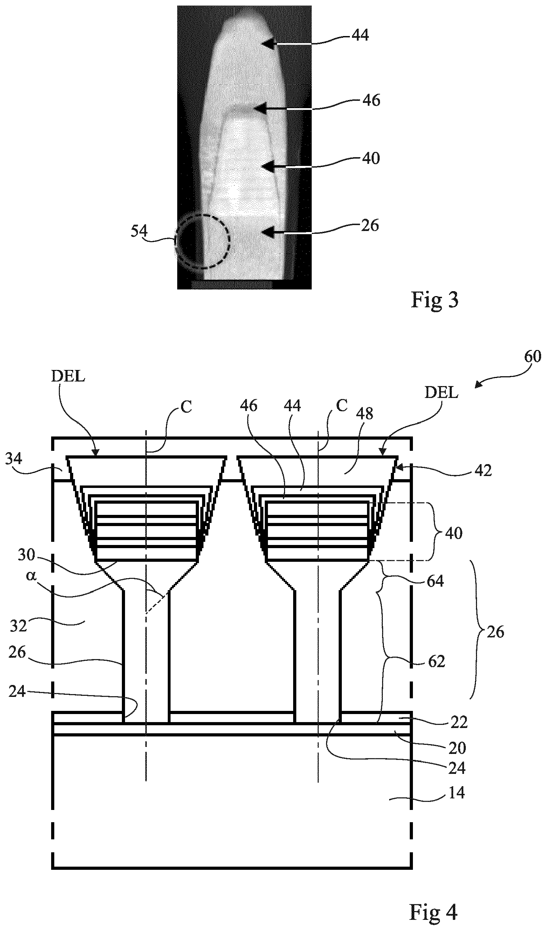

La figure 2 est une vue en coupe, partielle et schématique, analogue à la figure 1, illustrant la structure du dispositif optoélectronique 10 réellement obtenue et la figure 3 est une image, obtenue par microscopie électronique en transmission à balayage, de l'extrémité supérieure d'un fil 26, de la zone active 40 et de l'empilement semiconducteur 42 formés par MBE.

On peut observer, pour chaque diode électroluminescente DEL, la formation de passages 54 pour le courant entre la couche semiconductrice 44 et le fil 26 court-circuitant la zone active 40. Ceci entraîne une diminution des performances d'émission de la diode électroluminescente DEL.

Les inventeurs ont mis en évidence qu'en ajustant les conditions de croissance pour obtenir, pour chaque fil 26, une forme évasée au sommet du fil 26 et en mettant en oeuvre un procédé de croissance particulier au moins pour la formation de l'empilement semiconducteur 42, il est possible d'empêcher la formation des couches de l'empilement semiconducteur 42 directement au contact du fil 26 au moins au niveau du sommet du fil 26. Les procédés de croissance particuliers sont les procédés de croissance sous vide à une pression inférieure à 1,33 mPa (10⁻⁵ Torr), de préférence inférieure à 0,0133 mPa (10⁻⁷ Torr), pour lesquels des jets moléculaires sont projetés sur les surfaces sur lesquelles une croissance cristalline est souhaitée. Le procédé de croissance est par exemple la MBE ou la PA-MBE. En raison des faibles pressions, les jets moléculaires ont un comportement quasi-balistique. De ce fait, la forme évasée du sommet du fil 26 forme un écran bloquant les jets moléculaires et empêchant la formation des couches semiconductrices de l'empilement semiconducteur 42 sur les parois latérales du fil 26 au moins au niveau du sommet du fil 26.

La figure 4 est une vue en coupe d'un mode de réalisation d'un dispositif optoélectronique 60. Le dispositif optoélectronique 60 comprend l'ensemble des éléments du dispositif optoélectronique 10 représenté en figure 1 à la différence que chaque fil 26 comprend une portion inférieure 62 de section droite sensiblement constante se prolongeant par une portion supérieure 64 de forme évasée vers l'extérieur dans laquelle la section droite augmente selon l'axe C en s'éloignant du substrat 14. Comme cela apparaît sur cette figure, les couches de l'empilement semiconducteur 42 ne s'étendent pas au contact du fil 26 au moins au niveau du sommet du fil 26. Dans le mode de réalisation représenté en figure 4, la portion supérieure 64 comprend des facettes sensiblement planes inclinées par rapport à l'axe C d'un angle α. De façon générale, on appelle angle de la portion supérieure 64 le demi-angle au sommet du tronc de cône d'axe C à base circulaire dans lequel est inscrite la portion supérieure 64. Selon un mode de réalisation, l'angle α est strictement supérieur à 0°, de préférence entre 5° et 50°, plus préférentiellement entre 5° et 30°.

De préférence, pour chaque fil 26, le sommet 30 de la portion supérieure 62 du fil 26 correspond à une face sensiblement plane orthogonale à l'axe C du fil 26. De préférence, la surface du sommet 30 est supérieure d'au moins 20 % à la section droite de la portion inférieure 62 du fil 26. La hauteur de la portion supérieure 64 de chaque fil 26 mesurée selon l'axe C peut être comprise entre 5 nm et 2 µm, de préférence entre 20 nm et 500 nm. La hauteur de la portion inférieure 62 de chaque fil 26 mesurée selon l'axe C peut être comprise entre 200 nm et 5 µm. Pour chaque fil 26, le diamètre moyen de la portion inférieure 62 du fil 26, qui est le diamètre du disque de même surface que la section droite du fil 26, peut être compris entre 50 nm et 10 µm, de préférence entre 100 nm et 2 µm, de préférence entre 100 nm et 1 µm. La section droite de la portion inférieure 62 du fil 26 peut avoir différentes formes, par exemple ovale, circulaire ou polygonale, en particulier rectangulaire, carrée ou hexagonale.

Les fils 26, les couches semiconductrices 44 et les couches de liaison 48 peuvent être, au moins en partie, formés à partir de matériaux semiconducteurs comportant majoritairement un composé III-V, par exemple un composé III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple le phosphore ou l'arsenic. De façon générale, les éléments dans le composé III-V peuvent être combinés avec différentes fractions molaires. Les composés III-V des fils et des couches 44, 48 peuvent comprendre un dopant, par exemple du silicium qui est un dopant de type n pour les composés III-N ou du magnésium qui est un dopant de type p pour les composés III-N.

Le matériau semiconducteur du puits quantique ou des puits quantiques de la zone active 40 peut comprendre le composé III-V du fil 26 et de la couche semiconductrice 44 dans lequel au moins un élément supplémentaire est incorporé. A titre d'exemple, dans le cas de fils 26 constitués de GaN, l'élément supplémentaire est par exemple l'indium (In). Le pourcentage atomique de l'élément supplémentaire est fonction des propriétés optiques souhaitées et du spectre d'émission de la diode électroluminescente DEL. Lorsque la portion supérieure 64 du fil 26 n'est pas intentionnellement dopée, celle-ci peut remplacer l'une des couches barrières de la zone active 40.

La couche de blocage d'électrons 46 peut être formée en un alliage ternaire, par exemple en nitrure de gallium et d'aluminium (AlGaN) ou en nitrure d'indium et d'aluminium (AlInN).

Le substrat 14 peut correspondre à une structure monobloc ou correspondre à une couche recouvrant un support constitué d'un autre matériau. Le substrat 14 est de préférence un substrat semiconducteur, par exemple un substrat en silicium, en germanium, en carbure de silicium, en un composé III-V, tel que du GaN ou du GaAs, ou un substrat conducteur, par exemple un substrat métallique, notamment en cuivre, en titane, en molybdène, en un alliage à base de nickel ou en acier, ou un substrat en saphir. De préférence, le substrat 14 est un substrat de silicium monocristallin. De préférence, il s'agit d'un substrat semiconducteur compatible avec les procédés de fabrication mis en oeuvre en microélectronique. Le substrat 14 peut correspondre à une structure multicouches de type silicium sur isolant, également appelée SOI (acronyme anglais pour Silicon On Insulator).

La couche de germination 20 est en un matériau favorisant la croissance des fils 26. A titre d'exemple, le matériau composant la couche de germination 20 peut être un nitrure, un carbure ou un borure d'un métal de transition de la colonne IV, V ou VI du tableau périodique des éléments ou une combinaison de ces composés. A titre d'exemple, la couche de germination 20 peut être en nitrure d'aluminium (AlN). La couche de germination 20 peut avoir une structure monocouche ou correspondre à un empilement de deux couches ou de plus de deux couches.

La couche isolante 22 peut être en un matériau diélectrique, par exemple en oxyde de silicium (SiO₂) ou en nitrure de silicium (SiₓN_{y}, où x est environ égal à 3 et y est environ égal à 4, par exemple du Si₃N₄). A titre d'exemple, l'épaisseur de la couche isolante 22 est comprise entre 5 nm et 100 nm, par exemple égale à environ 30 nm. La couche isolante 22 peut avoir une structure monocouche ou correspondre à un empilement de deux couches ou de plus de deux couches.

La couche isolante 32 peut être en un matériau diélectrique, par exemple en oxyde de silicium (SiO₂) ou en nitrure de silicium (SiₓN_{y}, où x est environ égal à 3 et y est environ égal à 4, par exemple du Si₃N₄). La couche isolante 32 peut avoir une structure monocouche ou correspondre à un empilement de deux couches ou de plus de deux couches. A titre d'exemple, la couche isolante 32 peut être constituée d'un matériau polymère, d'un matériau inorganique ou d'une combinaison d'un matériau polymère et d'un matériau inorganique. A titre d'exemple, le matériau inorganique peut être de l'oxyde de titane (TiO₂) ou de l'oxyde d'aluminium (AlₓO_{y}, où x est environ égal à 2 et y est environ égal à 3, par exemple du Al₂O₃).

La couche d'électrode 34 est adaptée à polariser la zone active 40 recouvrant chaque fil 26 et à laisser passer le rayonnement électromagnétique émis par les diodes électroluminescentes DEL. Le matériau formant la couche d'électrode 34 peut être un matériau transparent et conducteur tel que de l'oxyde d'indium-étain (ou ITO, acronyme anglais pour Indium Tin Oxide), de l'oxyde de zinc dopé ou non à l'aluminium ou au gallium, ou du graphène. A titre d'exemple, la couche d'électrode 34 a une épaisseur comprise entre 5 nm et 200 nm, de préférence entre 20 nm et 50 nm.

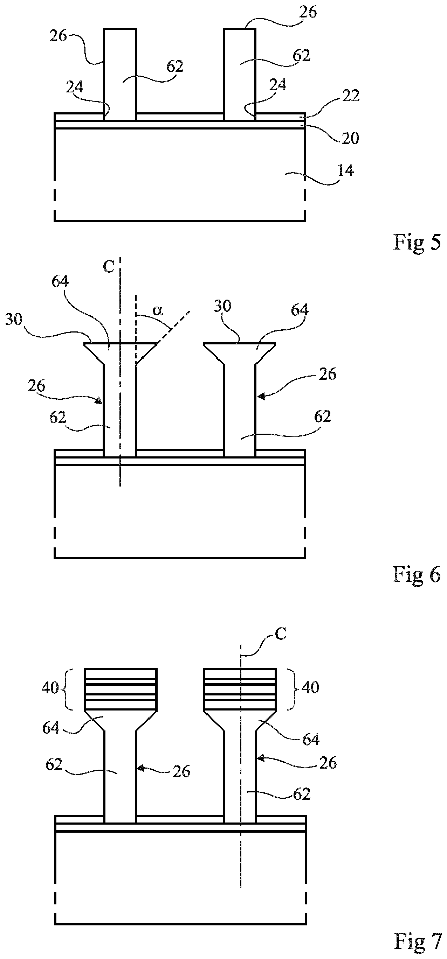

Les figures 5 à 8 sont des vues en coupe, partielles et schématiques, de la structure obtenue à des étapes successives d'un mode de réalisation d'un procédé de fabrication du dispositif optoélectronique 60 représenté en figure 4.

La figure 5 représente la structure obtenue après les étapes suivantes :
- formation sur le substrat 14 de la couche de germination 20 ;
- formation de la couche isolante 22 sur la couche de germination 20 ;
- formation des ouvertures 24 dans la couche isolante 22 pour exposer des portions de la couche de germination 20 aux emplacements souhaités des fils 26, le diamètre des ouvertures 24 correspondant sensiblement au diamètre moyen des portions inférieures 62 des fils 26 ; et
- croissance des portions inférieures 62 des fils 26 à partir de la couche de germination 20 dans les ouvertures 24.

La couche de germination 20 et la couche isolante 22 peuvent être formées par CVD, dépôt physique en phase vapeur (PVD, signe anglais pour Physical Vapor Déposition) ou ALD.

Selon un mode de réalisation, la croissance des portions inférieures 62 des fils 26 est réalisée par PA-MBE. La pression dans le réacteur est comprise entre 10⁻⁴ Torr (13,3 mPa) et 10⁻⁷ Torr (0,0133 mPa). Les conditions de croissance dans le réacteur sont adaptées pour favoriser une croissance préférentielle de la portion inférieure 62 de chaque fil 26 selon son axe C. Cela signifie que la vitesse de croissance du fil 26 selon l'axe C est nettement supérieure, de préférence d'au moins un ordre de grandeur, à la vitesse de croissance du fil 26 selon une direction perpendiculaire à l'axe C. On appelle rapport III/V le rapport entre le flux atomique de l'élément du groupe III et le flux atomique de l'élément du groupe V. Le rapport III/V est de préférence inférieur à 1,4, notamment compris entre 0,3 et 1,4, plus préférentiellement compris entre 0,35 et 1, par exemple égal à environ 0,8. La température dans le réacteur est, par exemple, comprise entre 600°C et 1000°C, de préférence entre 700°C et 950°C, plus préférentiellement entre 800°C et 925°C, par exemple environ 900°C.

La figure 6 représente la structure obtenue après la croissance des portions supérieures 64 des fils 26. Selon un mode de réalisation, la croissance des portions supérieures 64 des fils 26 est réalisée par PA-MBE. La pression dans le réacteur est comprise entre 10⁻⁴ et 10⁻⁷ Torr. Le rapport III/V est de préférence supérieur à 1,1, notamment compris entre 1,1 et 2, plus préférentiellement compris entre 1,3 et 1,6, par exemple égal à environ 1,4. La température dans le réacteur est inférieure à la température utilisée pour la formation des portions inférieures 62 des fils lorsqu'ils sont réalisés par MBE, de préférence d'au moins 50°C, par exemple comprise entre 550°C et 950°C, de préférence entre 650°C et 900°C, plus préférentiellement entre 750°C et 875°C, par exemple environ 850°C. Ceci permet d'obtenir un élargissement de la portion supérieure 64 de chaque fil 26, de préférence d'au moins 20 %. On obtient alors une portion supérieure 64 dont la paroi latérale forme l'angle α avec l'axe C comme cela a été décrit précédemment.

De façon avantageuse, lorsque les portions supérieures 64 des fils 26 sont formées par PA-MBE, les dimensions de la surface du sommet 30 de chaque portion supérieure 64, où est formée la zone active 40, sont sensiblement fixées par le rapport III/V utilisé pour la formation de la portion supérieure 64, et sont sensiblement indépendantes du diamètre moyen de la portion inférieure 62 du fil 26 depuis laquelle s'étend la portion supérieure 64. Ceci permet donc de commander avec précision les dimensions de la surface du sommet 30 de la portion supérieure 64 et donc les dimensions latérales de la zone active 40. Ceci permet de compenser au moins partiellement les variations des diamètres moyens des portions inférieures 62 des fils 26 qui peuvent résulter du procédé de fabrication des fils.

En outre, la longueur d'onde du rayonnement émis par un puits quantique dépend notamment de la proportion de l'élément supplémentaire du groupe III, par exemple l'indium, incorporé dans le composé ternaire du puits quantique. Cette proportion dépend elle-même des dimensions latérales de la zone active 40. De ce fait, un contrôle précis des dimensions latérales de la zone active 40 permet de contrôler avec précision la longueur d'onde du rayonnement émis par la zone active 40. Les variations des longueurs d'ondes du rayonnement émis par les diodes électroluminescentes peuvent donc être réduites.

La figure 7 représente la structure obtenue après la croissance des couches des zones actives 40. Selon un mode de réalisation, la croissance des couches des zones actives 40 est réalisée par PA-MBE. La pression dans le réacteur est comprise entre 10⁻⁴ et 10⁻⁷ Torr. Pour la formation du puits quantique ou de chaque puits quantique, un élément supplémentaire du groupe III est ajouté dans le réacteur. Le rapport entre les flux atomiques des éléments du groupe III et le flux atomique de l'élément du groupe V est égal au flux III/V utilisé pour la formation des portions supérieures 64 des fils 26 lorsqu'elles sont réalisées par MBE. La température dans le réacteur est, par exemple, comprise entre 500°C et 750°C, de préférence entre 600°C et 700°C.

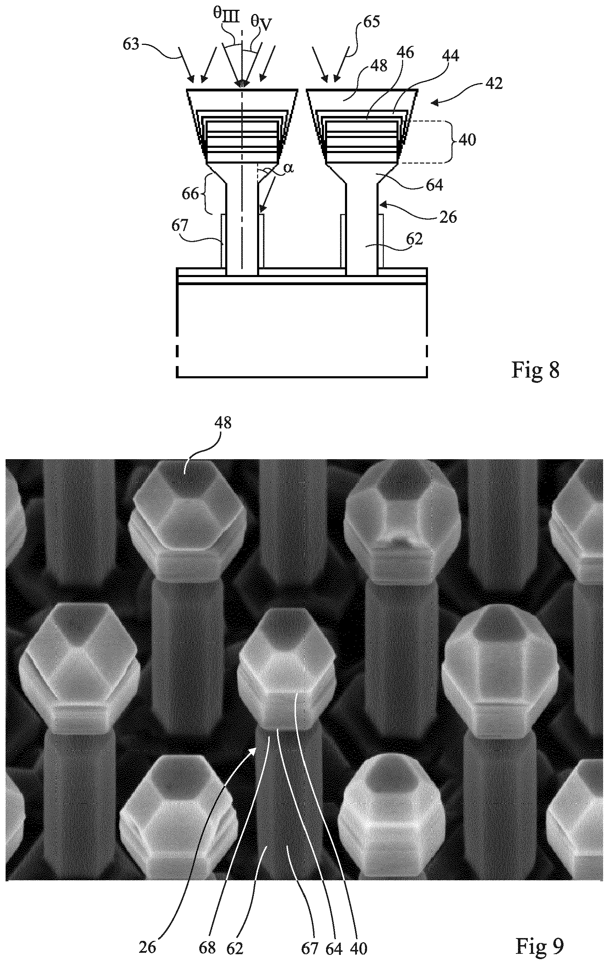

La figure 8 représente la structure obtenue après la croissance des couches des empilements semiconducteurs 42. Selon un mode de réalisation, la croissance des couches des empilements semiconducteurs 42 est réalisée par PA-MBE. La structure est en rotation dans le réacteur autour d'un axe vertical. La pression dans le réacteur est comprise entre 10⁻⁴ et 10⁻⁷ Torr. Pour la formation de la couche de blocage d'électrons 46, un élément supplémentaire du groupe III est ajouté dans le réacteur, le rapport III/V est de préférence proche de 1 et le rapport entre le flux atomique de l'élément supplémentaire et le flux atomique de l'élément du groupe V est compris entre 0,1 et 0,3. Pour la formation de la couche de blocage d'électrons 46, la température dans le réacteur est, par exemple, comprise entre 600°C et 1000°C, de préférence entre 700°C et 950°C, plus préférentiellement entre 750°C et 900°C. Pour la formation de la couche semiconductrice 44 ou 48, le rapport III/V est de préférence inférieur à 1,3, notamment compris entre 1,1 et 1,3. Pour la formation de la couche semiconductrice 44 ou 48, la température dans le réacteur est, par exemple, comprise entre 700°C et 900°C, de préférence entre 750°C et 850°C. Les flux atomiques de l'élément du groupe III et de l'élément du groupe V sont représentés de façon schématique en figure 8 par des flèches 63, 65. On appelle θ_{III} l'angle d'incidence du flux atomique de l'élément du groupe III et θ_{V} celui du flux atomique de l'élément du groupe V par rapport à l'axe C des fils. Les angles θ_{III} et θ_{V} dépendent notamment du type de réacteur utilisé. Lorsque le plus grand des angles θ_{III} et θ_{V} est inférieur à l'angle α, on obtient une zone 66 sur la portion inférieure 62 de chaque fil 26 où il n'y a pas de dépôt alors que l'on peut observer la formation d'un dépôt 67 non souhaité en partie basse de la portion inférieure 62 de chaque fil 26. Pour chaque fil 26, il n'y a pas de continuité entre les couches semiconductrices de l'empilement semiconducteur 42 et le dépôt 67 formé simultanément sur les parois latérales du fil 26, de sorte que la formation d'un court-circuit est empêchée.

Sur les figures 7 et 8, on a représenté chaque zone active 40 avec une section droite sensiblement constante selon l'axe C. A titre de variante, les conditions de croissance de la zone active 40 peuvent être sélectionnées de façon que la zone active 40 ait une forme de pyramide tronquée d'axe C avec une section droite qui diminue selon l'axe C en s'éloignant du substrat 14. Une telle forme peut être obtenue sans perte notable du volume du puits quantique ou des puits quantiques par rapport au cas où la section droite est constante. Une zone active 40 en forme de pyramide tronquée permet, de façon avantageuse, d'augmenter l'épaisseur de la couche semiconductrice 44 qui la recouvre et d'améliorer la passivation de la surface de la zone active 40.

Selon un autre mode de réalisation, la croissance des portions inférieures 62 des fils 26, et/ou des portions supérieures 64 des fils 26, et/ou des zones actives 40 est réalisée par un autre procédé qu'un procédé de dépôt en phase vapeur à une pression inférieure à 1,33 mPa (10⁻⁵ Torr), notamment par PA-MBE. Le procédé de croissance doit néanmoins permettre la formation de la portion supérieure 64 évasée de chaque fil 26.

Selon un autre mode de réalisation, la croissance des portions inférieures 62 des fils 26, et/ou des portions supérieures 64 des fils 26, et/ou des zones actives 40 est réalisée par MOCVD, par MBE, notamment MBE assistée par ammoniac, par épitaxie en couches minces atomiques (ALE, sigle anglais pour atomic layer epitaxy) . A titre d'exemple, le procédé peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac (NH₃), le tertiarybutylphosphine (TBT), l'arsine (AsH₃), ou le diméthylhydrazine asymétrique (UDMH). On appelle rapport III/V le rapport entre le flux de gaz du précurseur de l'élément du groupe III et le flux de gaz du précurseur de l'élément du groupe V.

La figure 9 est une image, obtenue par microscopie électronique à balayage, de l'extrémité supérieure de fils 26, des zones actives 40 et des empilements semiconducteurs 42 formés par MBE. Les portions inférieures 62 des fils 26 étaient en GaN dopé de type n. Le diamètre moyen de la portion inférieure 62 de chaque fil 26 était sensiblement égal à 500 nm. Les portions supérieures 64 des fils 26 étaient en GaN dopé de type n. Chaque zone active 40 comprenait dix puits quantiques en InGaN avec des couches barrières de GaN non dopé intentionnellement. Chaque empilement semiconducteur 42 comprenait une couche de blocage 46 en AlGaN et une couche semiconductrice 44 en GaN dopé de type p.

Les portions inférieures 62 des fils 26 ont été formées par MOCVD avec un rapport III/V de 0,1 et une température de 1050°C. Les portions supérieures 64 des fils 26 ont été formées par MBE avec un rapport Ga/N de 1,6 et une température de 850°C. Les puits quantiques en InGaN ont été formés par MBE avec un rapport Ga+In/N de 1,6 et une température de 750°C. Les couches de blocage 46 en AlGaN ont été formées par MBE avec un rapport (Ga+Al)/N de 1. Les couches semiconductrices 44 de GaN dopé de type p ont été formées par MBE avec un rapport Ga/N de 1 et une température de 850°C.

Comme cela apparaît sur la figure 9, on observe, pour chaque fil 26, un élargissement de la portion supérieure 64 du fil 26. En outre, on observe un dépôt 67 de GaN de type p sur les parois latérales du fil 26 seulement en partie basse du fil 26. La zone étranglée 68 du fil 26 correspond à la partie du fil 26 dans laquelle il n'y a pas de dépôt de GaN de type p en raison de l'ombrage fait par la portion supérieure 64 du fil 26.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. Enfin, la mise en oeuvre pratique des modes de réalisation et variantes décrits est à la portée de l'homme du métier à partir des indications fonctionnelles données ci-dessus. Les revendications qui suivent définissent l'étendue de la présente invention.

## Revendications

1. Procédé de fabrication d'un dispositif optoélectronique (60) comprenant des diodes électroluminescentes (DEL) comprenant la formation d'éléments semiconducteurs tridimensionnels (26), s'étendant selon des axes (C) parallèles, en un composé III-V, et comprenant chacun une portion inférieure (62) et une portion supérieure (64) évasée par rapport à la portion inférieure et inscrite dans un tronc de cône de demi-angle au sommet α, le procédé comprenant en outre, pour chaque élément semiconducteur, la formation d'une zone active (40) recouvrant le sommet (30) de la portion supérieure et la formation d'au moins une couche semiconductrice (44) du composé III-V recouvrant la zone active par dépôt sous phase vapeur à une pression inférieure à 10 mPa, en utilisant un flux de l'élément du groupe III selon une première direction inclinée d'un angle θ_{III} et un flux de l'élément du groupe V selon une deuxième direction inclinée d'un angle θ_{V} par rapport à l'axe vertical, **caractérisé en ce que** le plus grand des deux angles θ_{III} et θ_{V} est inférieur strictement à l'angle α.

2. Procédé selon la revendication 1, dans lequel les couches semiconductrices (44) sont formées par épitaxie par jets moléculaires.

3. Procédé selon la revendication 2, dans lequel le rapport III/V, pour la formation des couches semiconductrices (44), est inférieur à 1,4, de préférence inférieur à 1,3.

4. Procédé selon l'une quelconque des revendications 1 à 3, dans lequel l'angle α est strictement supérieur à 0°, de préférence compris entre 5° et 50°, plus préférentiellement compris entre 5° et 30°.

5. Procédé selon l'une quelconque des revendications 1 à 4, dans lequel les portions supérieures (64) des éléments semiconducteurs tridimensionnels (26) sont formées par épitaxie par jets moléculaires.

6. Procédé selon la revendication 5, dans lequel le rapport III/V, pour la formation des portions supérieures (64) des éléments semiconducteurs tridimensionnels (26), est supérieur à 1,1.

7. Procédé selon l'une quelconque des revendications 1 à 6, dans lequel les portions inférieures (62) des éléments semiconducteurs tridimensionnels (26) sont formées par épitaxie par jets moléculaires.

8. Procédé selon la revendication 7, dans lequel le rapport III/V, pour la formation des portions inférieures (62) des éléments semiconducteurs tridimensionnels (26), est inférieur à 1,4.

9. Procédé selon la revendication 7 dans son rattachement à la revendication 5, dans lequel la température lors de la formation des portions supérieures (64) des éléments semiconducteurs tridimensionnels (26) est inférieure d'au moins 50°C à la température lors de la formation des portions inférieures (62) des éléments semiconducteurs tridimensionnels (26).

10. Procédé selon l'une quelconque des revendications 1 à 9, dans lequel les zones actives (40) sont formées par épitaxie par jets moléculaires.

11. Procédé selon l'une quelconque des revendications 1 à 10, dans lequel les portions inférieures (62) des éléments semiconducteurs tridimensionnels (26) sont des microfils, des nanofils, des éléments coniques de taille micrométrique ou nanométrique, ou des éléments tronconiques de taille micrométrique ou nanométrique.

12. Procédé selon l'une quelconque des revendications 1 à 11, dans lequel les zones actives (40) sont les régions depuis lesquelles est émise la majorité du rayonnement électromagnétique fourni par les diodes électroluminescentes (DEL).

## Patentansprüche

1. Verfahren zur Herstellung einer optoelektronischen Vorrichtung (60) mit lichtemittierenden Dioden (DEL), aufweisend das Ausbilden von dreidimensionalen Halbleiterelementen (26), die sich entlang paralleler Achsen (C) erstrecken, aus einer III-V-Verbindung bestehen und jeweils einen unteren Abschnitt (62) und einen oberen Abschnitt (64) aufweisen, der in Bezug auf den unteren Abschnitt aufgeweitet ist und in einen Kegelstumpf mit einem halben Scheitelwinkel α eingeschrieben ist, wobei das Verfahren ferner für jedes Halbleiterelement Folgendes aufweist, das Ausbilden eines aktiven Bereichs (40), der die Oberseite (30) des oberen Abschnitts bedeckt, und das Ausbilden mindestens einer Halbleiterschicht (44) aus der III-V-Verbindung, die den aktiven Bereich bedeckt, mittels Dampfabscheidung bei einem Druck von weniger als 10 mPa, unter Verwendung eines Flusses des Gruppe-III-Elements entlang einer ersten Richtung, die um einen Winkel θ_{III} geneigt ist, und eines Flusses des Gruppe-V-Elements entlang einer zweiten Richtung, die um einen Winkel θ_{V} bezüglich der Vertikalachse geneigt ist, **dadurch gekennzeichnet, dass** der größte der beiden Winkel θ_{III} und θ_{V} kleiner als der Winkel α ist.

2. Verfahren nach Anspruch 1, wobei die Halbleiterschichten (44) durch Molekularstrahlepitaxie gebildet werden.

3. Verfahren nach Anspruch 2, wobei das III/V-Verhältnis bei der Bildung der Halbleiterschichten (44) kleiner als 1,4, vorzugsweise kleiner als 1,3 ist.

4. Verfahren nach einem der Ansprüche 1 bis 3, wobei der Winkel α größer als 0° ist, vorzugsweise im Bereich von 5° bis 50°, besonders bevorzugt im Bereich von 5° bis 30°.

5. Verfahren nach einem der Ansprüche 1 bis 4, wobei die oberen Bereiche (64) der dreidimensionalen Halbleiterelemente (26) durch Molekularstrahlepitaxie gebildet werden.

6. Verfahren nach Anspruch 5, wobei das III/V-Verhältnis für die Bildung der oberen Abschnitte (64) der dreidimensionalen Halbleiterelemente (26) größer als 1,1 ist.

7. Verfahren nach einem der Ansprüche 1 bis 6, wobei die unteren Abschnitte (62) der dreidimensionalen Halbleiterelemente (26) durch Molekularstrahlepitaxie gebildet werden.

8. Verfahren nach Anspruch 7, wobei das III/V-Verhältnis für die Bildung der unteren Abschnitte (62) der dreidimensionalen Halbleiterelemente (26) kleiner als 1,4 ist.

9. Verfahren nach Anspruch 7 in Abhängigkeit von Anspruch 5, wobei die Temperatur beim Ausbilden der oberen Abschnitte (64) der dreidimensionalen Halbleiterelemente (26) um mindestens 50°C geringer ist als die Temperatur beim Ausbilden der unteren Abschnitte (62) der dreidimensionalen Halbleiterelemente (26).

10. Verfahren nach einem der Ansprüche 1 bis 9, wobei die aktiven Bereiche (40) durch Molekularstrahlepitaxie gebildet werden.

11. Verfahren nach einem der Ansprüche 1 bis 10, wobei die unteren Abschnitte (62) der dreidimensionalen Halbleiterelemente (26) Mikrodrähte, Nanodrähte, konische Elemente im Mikrometer- oder Nanometerbereich oder kegelstumpfförmige Elemente im Mikrometer- oder Nanometerbereich sind.

12. Verfahren nach einem der Ansprüche 1 bis 11, wobei die aktiven Bereiche (40) die Bereiche sind, aus denen der größte Teil der von den Leuchtdioden (DEL) gelieferten elektromagnetischen Strahlung emittiert wird.

## Claims

1. Method of manufacturing an optoelectronic device (60) comprising light-emitting diodes (DEL) comprising the forming of three-dimensional semiconductor elements (26), extending along parallel axes (C), made of a III-V compound, and each comprising a lower portion (62) and an upper portion (64) flared with respect to the lower portion and inscribed within a frustum having a half apical angle α, the method further comprising, for each semiconductor element, the forming of an active area (40) covering the top (30) of the upper portion and the forming of at least one semiconductor layer (44) of the III-V compound covering the active area by vapor deposition at a pressure lower than 10 mPa, by using a flux of the group-III element along a first direction inclined by an angle θ_{III} and a flux of the group-V element along a second direction inclined by an angle θ_{V} with respect to the vertical axis, **characterized in that** the largest of the two angles θ_{III} and θ_{V} is smaller than angle α.

2. Method according to claim 1, wherein the semiconductor layers (44) are formed by molecular beam epitaxy.

3. Method according to claim 2, wherein the III/V ratio, for the forming of the semiconductor layers (44), is smaller than 1.4, preferably smaller than 1.3.

4. Method according to any of claims 1 to 3, wherein angle α is greater than 0°, preferably in the range from 5° to 50°, more preferably in the range from 5° to 30°.

5. Method according to any of claims 1 to 4, wherein the upper portions (64) of the three-dimensional semiconductor elements (26) are formed by molecular beam epitaxy.

6. Method according to claim 5, wherein the III/V ratio, for the forming of the upper portions (64) of the three-dimensional semiconductor elements (26), is greater than 1.1.

7. Method according to any of claims 1 to 6, wherein the lower portions (62) of the three-dimensional semiconductor elements (26) are formed by molecular beam epitaxy.

8. Method according to claim 7, wherein the III/V ratio, for the forming of the lower portions (62) of the three-dimensional semiconductor elements (26), is smaller than 1.4.

9. Method according to claim 7 as dependent on claim 5, wherein the temperature during the forming of the upper portions (64) of the three-dimensional semiconductor elements (26) is smaller by at least 50°C than the temperature during the forming of the lower portions (62) of the three-dimensional semiconductor elements (26) .

10. Method according to any of claims 1 to 9, wherein the active areas (40) are formed by molecular beam epitaxy.

11. Method according to any of claims 1 to 10, wherein the lower portions (62) of the three-dimensional semiconductor elements (26) are microwires, nanowires, micrometer- or nanometer-range conical elements, or micrometer- or nanometer-range frustoconical elements.

12. Method according to any of claims 1 to 11, wherein the active areas (40) are the regions having most of the electromagnetic radiation supplied by the light-emitting diodes (DEL) emitted therefrom.
